# EUROPEAN PATENT SPECIFICATION

(11) **EP 4 095 890 B1**
(45) Date of publication and mention of the grant of the patent: **04.11.2026**
(21) Application number: 20924109.0
(22) Date of filing: 10.03.2020
(51) Int. Cl.: H10W 90/26, H10W 90/00, H10W 46/00, H10W 72/00, H10W 72/20, H10W 74/01, H10W 74/10

(54) **CHIP STACKING STRUCTURE, MANUFACTURING METHOD, AND ELECTRONIC DEVICE**
CHIPSTAPELSTRUKTUR, HERSTELLUNGSVERFAHREN UND ELEKTRONISCHE VORRICHTUNG
STRUCTURE D'EMPILEMENT DE PUCES, PROCÉDÉ DE FABRICATION ET DISPOSITIF ÉLECTRONIQUE

(43) Date of publication of application: 30.11.2022
(73) Proprietor: Huawei Technologies Co., Ltd., Shenzhen, Guangdong 518129 (CN)
(72) Inventor: LI, Heng, Shenzhen, Guangdong 518129 (CN); ZHANG, Xiaodong, Shenzhen, Guangdong 518129 (CN); WANG, Simin, Shenzhen, Guangdong 518129 (CN); QI, Xiaoyun, Shenzhen, Guangdong 518129 (CN)
(74) Representative: Epping - Hermann - Fischer
(86) International application number: PCT/CN2020/078676
(87) International publication number: WO 2021/179185

(56) References cited:
- WO-A1-2011/105961
- CN-A- 101 390 217
- CN-A- 102 496 604
- US-A- 4 818 728
- US-A- 5 384 952
- US-A1- 2005 266 670
- US-A1- 2007 040 272
- US-A1- 2007 145 553

## Description

### TECHNICAL FIELD

Embodiments of this disclosure relate to the field of electronic packaging technologies, and in particular, to a chip stacking structure, a method for manufacturing the chip stacking structure, and an electronic device.

### BACKGROUND

As a size of an electronic device decreases, high integration may be achieved by stacking a plurality of chips in one semiconductor package assembly or stacking a plurality of separate semiconductor package assemblies. Based on this, in the conventional technology, when the foregoing electronic device is manufactured, different chips are usually electrically connected together by using an electrical connector.

Reducing a pitch between electrical connectors can greatly improve integration of packaging, thereby facilitating miniaturization of the electronic device. The pitch between the electrical connectors may be expressed as a distance between the center of one electrical connector and the center of an adjacent electrical connector.

However, when the pitch between the electrical connectors is further reduced, if transverse sizes of the electrical connectors are reduced, a size of a welding surface between the electrical connectors and pads is correspondingly reduced, which may cause an open circuit. If a spacing between adjacent electrical connectors is reduced, a short circuit is likely to occur, which affects a manufacturing yield of a chip.

Document WO 2011/105961 A1 relates to a chip assembly and a method of stacking chips. The method includes providing a first substrate, wherein, on or within a surface of the first substrate, a first contact structure is arranged. The first contact structure includes an intermediate layer and at least one contact for contacting the first substrate, wherein the intermediate layer is provided on the surface of the first substrate and has at least one recess. The at least one recess accommodates or allows access to the at least one contact. The method provides a second substrate, wherein on a surface of the second substrate, a second contact structure is arranged, and the second contact structure has at least one contact. Moreover, the method comprises a step of inserting the second contact structure into the at least one recess of the intermediate layer.

Document US 2007/040272 A1 describes a method of semiconductor chip packaging on a flexible substrate. The chip and the flexible substrate are provided with corresponding raised and indented micron-scale contact pads with the indented contact pads partially filled with a liquid amalgam. After low temperature amalgam curing, the chip and the substrate form a flexible substrate IC packaging with high conductivity, controllable interface layer thickness, micron-scale contact density and low process temperature. Adhesion between the chip and the substrate can be further enhanced by coating other areas with non-conducting adhesive.

Document US 2005/266670 A1 describes a bonding process. A bump is formed on a first electric device. A patterned insulation layer is formed on a second electric device, wherein an opening is in the patterned insulation layer and exposes the second electric device. The bump is joined to the second electric device exposed by the opening in the patterned insulation layer.

### SUMMARY

Embodiments of this disclosure provide a chip stacking structure, a method for manufacturing the chip stacking structure, and an electronic device, to resolve a problem that reducing a pitch between electrical connectors affects a manufacturing yield of a chip.

The present invention is set out by the set of appended claims. In the following, parts of the description and drawing referring to examples or implementations, which are not covered by the claims are not presented as embodiments of the invention, but as illustrative examples useful for understanding the invention. The embodiments of the invention are provided by the set of appended claims.

To achieve the foregoing objective, the embodiments of this disclosure use the following technical solutions.

A chip stacking structure is provided, including a first chip and a second chip that are disposed in a stacked manner, where a first surface of the first chip is opposite to a second surface of the second chip. A plurality of pads are disposed on the first surface of the first chip, a plurality of electrical connectors are disposed on the second surface of the second chip, and the plurality of pads are connected to the plurality of electrical connectors in a one-to-one correspondence. A plurality of isolation components made of insulation materials are further disposed on the first surface of the first chip, the isolation component is located between adjacent pads, a height of the isolation component is less than or equal to a sum of heights of the electrical connector and the pad, and a gap between the electrical connector and the pad is filled with solder. Therefore, the isolation component is disposed between adjacent electrical connectors to isolate the adjacent electrical connectors. When the electrical connector is connected to the pad, the solder is isolated by the isolation component, thereby avoiding a short circuit caused by the melted solder flowing when the electrical connector is welded to the pad. More solder, larger pressure, or a longer welding time may further be used during welding, greatly reducing a risk of an open circuit.

In the invention, the gap between the electrical connector and the isolation component is filled with the solder. Therefore, the solder fills the gap between the electrical connector and the isolation component, thereby further improving stability of the electrical connector, reducing the risk of the open circuit, and improving a manufacturing yield.

In an optional implementation, the isolation component includes an isolation plate disposed between the adjacent pads. Therefore, the isolation component of a plate-shaped structure occupies smaller space, which facilitates device miniaturization.

The isolation component includes an annular groove disposed around the pad. Therefore, when the electrical connector is welded to the pad, the solder between the electrical connector and the pad is melted to fill the annular groove, so that a connection between the electrical connector and the pad is more stable. In addition, for electrical connectors of different heights, more solder needs to be added to only heads of the electrical connectors, so that shapes of the finally formed electrical connectors match a shape of the annular groove. Height consistency tolerance of the electrical connectors is higher, which improves consistency of the electrical connectors and stability of the connection.

In an optional implementation, a longitudinal section of the annular groove is a trapezoid, and a size of an opening on a side that is of the annular groove and that is close to the pad is less than a size of a section on a side that is of the isolation component and that is close to the electrical connector. Therefore, an inner sidewall of the annular groove may guide the electrical connector, so that the electrical connector more easily enters the annular groove. In addition, the inner sidewall of the annular groove may block the electrical connector from tilting in a pressing process of the electrical connector, to prevent a mechanism such as the electrical connector from tilting due to uneven force or another reason in the pressing process.

In an optional implementation, a longitudinal section of the annular groove is a rectangle. Therefore, a size of space occupied by the annular groove is reduced, thereby facilitating device miniaturization.

In an optional implementation, a cross section of the annular groove is a circle, a square, a regular polygon, or an irregular shape. Therefore, the shape of the annular groove is more flexible, and a suitable isolation component may be selected based on the chip.

In an optional implementation, the electrical connector includes a first subpart close to the second chip and a second subpart close to the pad, a material of the first subpart includes at least one of copper or gold, and a material of the second subpart includes solder. In this case, the first subpart may provide a specific hardness for an interconnection terminal. In addition, performing a spot welding process on the second subpart may connect the interconnection terminal to the pad.

In the invention, the gap between the isolation component and the second chip is filled with a filler. Therefore, the filler may be used to support the second chip, and may further be used to conduct heat, thereby facilitating heat dissipation of the device.

A method for manufacturing a chip stacking according to claim 4 is provided.

Therefore, the isolation component is disposed between adjacent electrical connectors to isolate the adjacent electrical connectors. More solder may be used when the electrical connector is connected to the pad, and the solder is isolated by the isolation component, thereby avoiding a short circuit caused by the melted solder flowing when the electrical connector is welded to the pad. More solder, larger pressure, or a longer welding time may further be used during welding, greatly reducing a risk of an open circuit.

In the invention, the method further includes: extruding the first chip and the second chip, so that the solder between the electrical connector and the pad flows to a gap between the electrical connector and the isolation component. Therefore, the solder fills the gap between the electrical connector and the isolation component, thereby further improving stability of the electrical connector, reducing the risk of the open circuit, and improving a manufacturing yield. In addition, a manufacturing process of a stacking component is simple and costs are low, thereby helping reduce packaging costs of the stacking component.

In an optional implementation, before the forming a passivation layer on a first surface of a first chip, the method further includes: performing surface processing on the pad, so that a surface of the pad forms a reaction layer, and a metallurgical reaction occurs between the reaction layer and the electrical connector during heating. A material of the reaction layer may be NiAu. Au has good solderability, and Ni prevents an excessive metallurgical reaction. Therefore, under an effect of heating or another external condition, diffusion of metal atomic bonds can be accelerated, a connection interface can be eliminated, and an intermetallic compound can be formed, to obtain interconnection of to-be-connected objects on both sides. Reliability of interconnection between the pad and the electrical connector can be enhanced.

In the invention, after the electrical connectors are welded to the pads one by one, the method further includes: filling a gap between the isolation component and the second chip with a filler.

In an optional implementation, the isolation component includes an isolation plate disposed between the adjacent pads.

The isolation component includes an annular groove disposed around the pad.

In an optional implementation, a longitudinal section of the annular groove is a trapezoid, and a size of a section on a side that is of the isolation component and that is close to the pad is less than a size of a section on a side that is of the isolation component and that is close to the electrical connector.

In an optional implementation, a size of an opening on a side that is of the annular groove and that is close to the electrical connector is greater than a size of a head of the electrical connector.

In an optional implementation, a cross section of the annular groove is a circle, a square, a regular polygon, or an irregular shape.

In an optional implementation, the electrical connector includes a first subpart close to the second chip and a second subpart close to the pad, a material of the first subpart includes at least one of copper or gold, and a material of the second subpart includes solder.

An electronic device is provided, including a printed circuit board and the foregoing chip stacking structure, where the chip stacking structure is electrically connected to the printed circuit board. Therefore, the electronic device uses the foregoing chip stacking structure, so that connection stability is higher and a size is smaller, thereby facilitating device miniaturization.

### BRIEF DESCRIPTION OF DRAWINGS

FIG. 1 is a schematic diagram of a cross-sectional structure of a chip stacking structure;
FIG. 2 is a schematic diagram of a cross-sectional structure of a chip stacking structure according to an example of this disclosure;
FIG. 3 is a schematic diagram of a cross-sectional structure of a chip stacking structure according to an example of this disclosure;
FIG. 4A is a schematic diagram of a structure of an electrical connector according to an example of this disclosure;
FIG. 4B is a schematic diagram of a structure of another electrical connector according to an example of this disclosure;
FIG. 4C is a schematic diagram of a structure of another electrical connector according to an example of this disclosure;
FIG. 5A is a schematic diagram of a cross-sectional structure of an isolation structure according to an example of this disclosure;
FIG. 5B is a schematic diagram of a cross-sectional structure of another isolation structure according to an example of this disclosure;
FIG. 6A is a top view of the isolation structure in FIG. 5A;
FIG. 6B is another top view of the isolation structure in FIG. 5A;
FIG. 6C is another top view of the isolation structure in FIG. 5A;
FIG. 6D is a top view of the isolation structure in FIG. 5B;
FIG. 7 is a flowchart of a method for manufacturing a chip stacking structure according to an example of this disclosure;
FIG. 8A, FIG. 8B, and FIG. 8C are respectively schematic diagrams of structures of products obtained by performing steps in FIG. 7;
FIG. 9 is a flowchart of another method for manufacturing a chip stacking structure according to an example of this disclosure;
FIG. 10 is a schematic diagram of a structure of a product obtained by performing steps in FIG. 9;
FIG. 11 is a flowchart of another method for manufacturing a chip stacking structure according to an example of this disclosure;
FIG. 12 is a schematic diagram of a structure of a product obtained by performing steps in FIG. 11;
FIG. 13 is a flowchart of another method for manufacturing a chip stacking structure according to an example of this disclosure;
FIG. 14 is a schematic diagram of a structure of a product obtained by performing steps in FIG. 13;
FIG. 15 is a flowchart of another method for manufacturing a chip stacking structure according to an example of this disclosure;
FIG. 16 is a schematic diagram of a structure of a product obtained by performing steps in FIG. 15; and
FIG. 17 is a schematic diagram of a cross-sectional structure of an electronic device according to an example of this disclosure.

### DETAILED DESCRIPTION

The following describes implementations of examples of this disclosure in detail with reference to accompanying drawings.

The following terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more of the features. In the descriptions of this disclosure, unless otherwise stated, "a plurality of" means two or more than two.

In addition, in this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

The following explains terms that may appear in examples of this disclosure.

A pitch is a marked distance between the centers of any two objects on a surface of a board. If objects are arranged continuously and widths of the objects and spacings between the objects are the same, a "center-to-center spacing" is also referred to as a pitch.

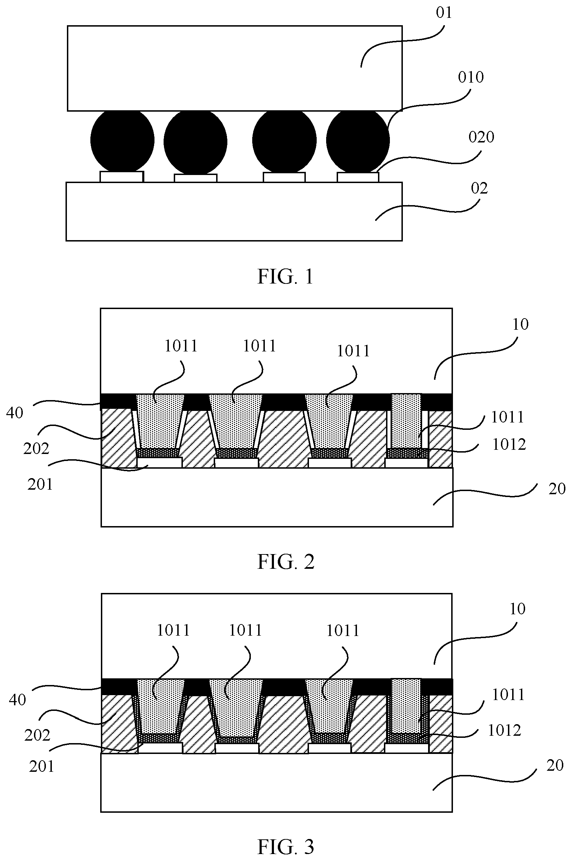

FIG. 1 is a schematic diagram of a cross-sectional structure of a chip stacking structure. As shown in FIG. 1, the stacking structure includes: a first chip 01 and a second chip 02 that are disposed in a stacked manner, where a first surface of the first chip 01 is opposite to a second surface of the second chip 02, solder balls 010 are disposed on the first surface of the first chip 01, pads 020 are disposed on the second surface of the second chip 02, the solder balls 010 one-to-one correspond to the pads 020, and the solder balls 010 are welded to the pads 020 in a one-to-one correspondence.

Currently, a pitch between solder balls 010 is relatively large, and this process leads to low integration of the stacking structure. With development of electronic device technologies, a process with a smaller spacing is required to implement welding of upper and lower substrates, so as to improve integration of a stacking component.

Therefore, an example of this disclosure provides a stacking structure of a device. FIG. 2 is a schematic diagram of a cross-sectional structure of a chip stacking structure according to an example of this disclosure. The stacking structure includes: a first chip 20 and a second chip 10.

The first chip 20 and the second chip 10 each include a first surface and a second surface that are opposite to each other. The second surface of the second chip 10 is opposite to the first surface of the first chip 20.

It should be noted that the first surface of the first chip 20 is an upper surface of the first chip 20 in FIG. 2, and the second surface of the second chip 10 is a lower surface of the second chip 10 in FIG. 2.

A plurality of electrical connectors 1011 are disposed on the second surface of the second chip 10, and a plurality of pads 201 are disposed on the first surface of the first chip 20. The plurality of pads 201 one-to-one correspond to the plurality of electrical connectors 1011, and the plurality of electrical connectors 1011 are welded to the plurality of pads 201.

It should be noted that a quantity of first chips 20 and a quantity of second chips 10 are not limited in this application. In addition, the first chip 20 and the second chip 10 generally have different functions. For example, in an implementation of this disclosure, the second chip 10 may be a logical chip, and the first chip 20 may be a storage chip. In this case, when the stacking structure has a plurality of logic chips used as second chips 10, the plurality of second chips 10 may be located in a same plane and disposed at intervals.

For example, there are a plurality of electrical connectors 1011, and the electrical connectors 1011 are arranged continuously. Widths of the electrical connectors 1011 and spacings between the electrical connectors 1011 are the same. Therefore, a pitch between electrical connectors 1011 is a distance between the center of an electrical connector 1011 and the center of an adjacent electrical connector 1011. Reducing the pitch between the electrical connectors 1011 can greatly improve integration of packaging, thereby bringing significant benefits.

However, when the pitch between the electrical connectors 1011 is further reduced, if transverse sizes of the electrical connectors 1011 are reduced, a size of a welding surface between the electrical connectors 1011 and the pads 201 is correspondingly reduced, which may cause an open circuit. If a spacing between adjacent electrical connectors 1011 is reduced, a short circuit is likely to occur, which affects a manufacturing yield of the chip.

In this example, a plurality of isolation components 202 are disposed between adjacent pads 201, a height of the isolation component 202 is less than or equal to a sum of heights of the electrical connector 1011 and the pad 201, and solder 1012 is filled between the electrical connector 1011 and the pad 201. Therefore, the isolation component is disposed between the adjacent electrical connectors to isolate the adjacent electrical connectors. More solder may be used when the electrical connector is connected to the pad, and the solder is isolated by the isolation component, thereby avoiding a short circuit caused by the melted solder flowing when the electrical connector is welded to the pad. More solder, larger pressure, or a longer welding time may further be used during welding, greatly reducing a risk of an open circuit.

FIG. 3 is a schematic diagram of a cross-sectional structure of another chip stacking structure according to an example of this disclosure. As shown in FIG. 3, in another implementation of this disclosure, the solder 1012 is also filled between the electrical connector 1011 and the isolation component 202. Therefore, the solder 1012 fills a gap between the electrical connector 1011 and the isolation component 202, so that electrical connection stability of the electrical connector can be further improved. Stability of each electrical connector is improved, and a total quantity of electrical connectors can be reduced while connection stability is ensured, thereby reducing sizes of the first chip and the second chip, and facilitating device miniaturization.

It should be noted that the solder is a filler added in or beside a gap between the electrical connector 1011 and the pad 201 to combine the electrical connector 1011 and the pad 201. A material of the solder 1012 is not limited in this example of this disclosure. Tin-lead solder, silver solder, copper solder, or the like may be used. The tin-lead solder, for example, includes tin and lead, and further includes trace metal components such as antimony.

The isolation component 202 may be made of an insulation material, for example, may be an organic material such as polybenzoxazole (PBO) or polyimide (PI), acrylic acid, or benzocyclobutene (BCB), or an inorganic material such as oxide or nitride. The isolation component 202 is a film layer formed by using a rotary coating process.

It should be noted that a specific material of the isolation component 202 is not limited in this example of this disclosure.

According to the stacking structure provided in this example of this disclosure, when the pitch between the electrical connectors 1011 is reduced, the isolation component 202 is disposed between the adjacent electrical connectors 1011 to isolate the adjacent electrical connectors 1011. More solder may be used when the electrical connector 1011 is connected to the pad 201, and the solder is isolated by the isolation component 202, thereby avoiding the short circuit caused by the solder flowing when the electrical connector 1011 is welded to the pad 201. Larger pressure or the longer welding time may further be used during welding, thereby greatly reducing the risk of the open circuit, improving a welding yield, and improving connection stability. Therefore, the manufacturing yield of the chip can be considered while the pitch is reduced.

A specific structure of the isolation component 202 is not limited in this example of this disclosure. In an implementation of this disclosure, the isolation component 202 is of a plate-shaped structure, and is disposed between the adjacent electrical connectors 1011.

For example, the plate-shaped structure is located between a first electrical connector and a second electrical connector that are adjacent to each other. The plate-shaped structure includes a first surface and a second surface that are opposite to each other. The first surface of the plate-shaped structure is close to the first electrical connector, and the second surface of the plate-shaped structure is, for example, close to the second electrical connector.

A shape of the plate-shaped structure is not limited in this example of this disclosure, and the shape of the plate-shaped structure matches, for example, a shape of an adjacent electrical connector 1011. In an implementation of this disclosure, as shown in FIG. 3, if both cross sections of the first electrical connector and the second electrical connector are inverted trapezoids, a cross section shape of the plate-shaped structure may be a regular trapezoid. If both the cross sections of the first electrical connector and the second electrical connector are rectangles, the cross section shape of the plate-shaped structure may be a rectangle.

Therefore, the plate-shaped structure matches the shape of the adjacent electrical connector 1011, thereby reducing assembly difficulty and facilitating assembly.

The gap between the electrical connector 1011 and the pad 201 and a gap between a sidewall of the electrical connector 1011 and a sidewall of the plate-shaped structure are filled with solder. The isolation component 202 of the plate-shaped structure occupies smaller space and saves more space.

If the first electrical connector is adjacent to only the second electrical connector, the isolation component of the plate-shaped structure may be disposed only between the first electrical connector and the second electrical connector. If the first electrical connector is adjacent to a plurality of electrical connectors, an example of this disclosure further provides an isolation component 202 of an annular groove structure. The annular groove structure is, for example, disposed around the first electrical connector, so that the first electrical connector can be better isolated from the other electrical connectors.

An annular groove is equivalent to a blocking part for tilting the electrical connector in a pressing process, to prevent a mechanism such as the electrical connector from tilting due to uneven force or another reason in the pressing process.

When the electrical connector 1011 is welded to the pad 201, the solder between the electrical connector 1011 and the pad 201 melts to fill the annular groove, so that solder is filled in the gap between the electrical connector 1011 and the pad 201 and a gap between an outer sidewall of the electrical connector 1011 and an inner sidewall of the annular groove structure. In this way, a connection between the electrical connector 1011 and the pad 201 is more stable.

In addition, for electrical connectors 1011 of different heights, only an amount of solder between the electrical connectors 1011 and pads 201 needs to be adjusted. For example, more solder may be filled for an electrical connector 1011 of a small height, and less solder may be filled for an electrical connector 1011 of a large height. A shape of a finally formed electrical connector 1011 matches a shape of the annular groove. Height consistency tolerance of the electrical connectors 1011 is higher, which improves consistency of the electrical connectors 1011 and stability of the connection.

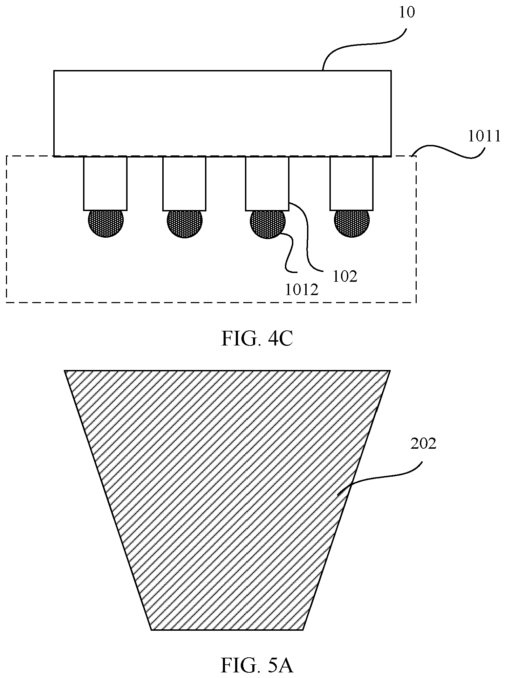

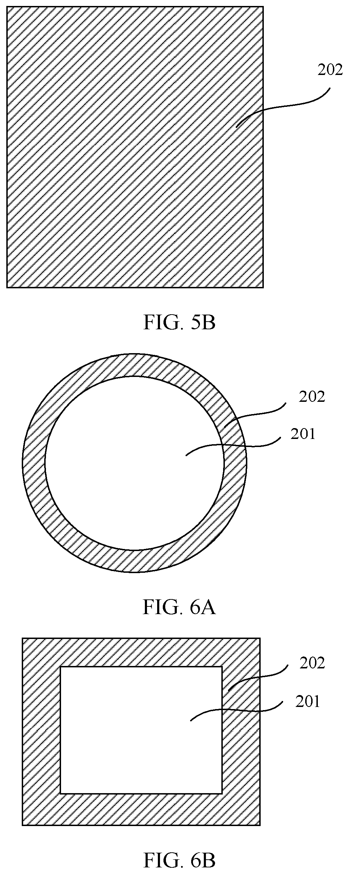

The following further describes the isolation component 202 of the annular groove structure. FIG. 5A and FIG. 5B are schematic diagrams of cross-sectional structures of the isolation component 202, and the isolation component 202 may be trapezoidal or rectangular.

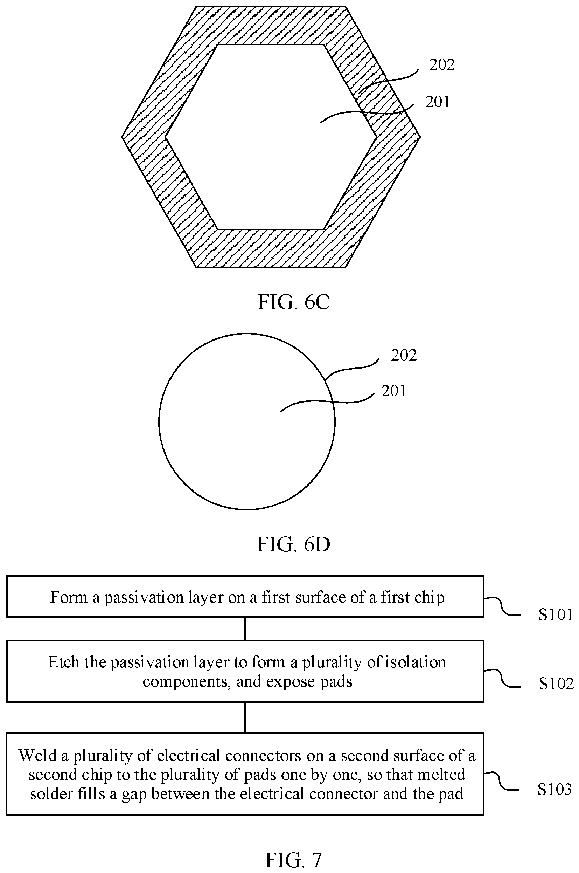

Thicknesses of the isolation components are uniform. FIG. 6A, FIG. 6B, and FIG. 6C show top views corresponding to the isolation component 202 in FIG. 5A. When a longitudinal section of the isolation component 202 is a trapezoid, the top view of the isolation component 202 may be a circular ring, a square ring, or a regular multilateral ring. A size of an opening on a side that is of the isolation component 202 whose longitudinal section is a trapezoid and that is close to the pad 201 is less than a size of an opening on a side that is of the isolation component 202 and that is close to the electrical connector 1011, so that the electrical connector 1011 more easily enters the annular groove. FIG. 6D shows a top view of the isolation component 202 in FIG. 5B. When a longitudinal section of the isolation component 202 is a rectangle, the top view of the isolation component 202 may be a circle. Certainly, the top view of the isolation component 202 may alternatively be a square, a regular polygon, or an irregular shape. Sizes of upper and lower openings of the isolation component whose longitudinal section is a rectangle are the same, thereby saving more space.

A specific structure of the electrical connector 1011 is not limited in this example of this disclosure. For example, the electrical connector 1011 may be a micro bump (uBump), a controlled collapse chip connection (C4), a copper pillar (Cu Pillar), or the like. A minimum pitch of the controlled collapse chip connection may be reduced to about 130 um, a minimum pitch of the copper pillar may be reduced to 60 um, and a pitch of the micro bump is reduced to 30 um to 40 um.

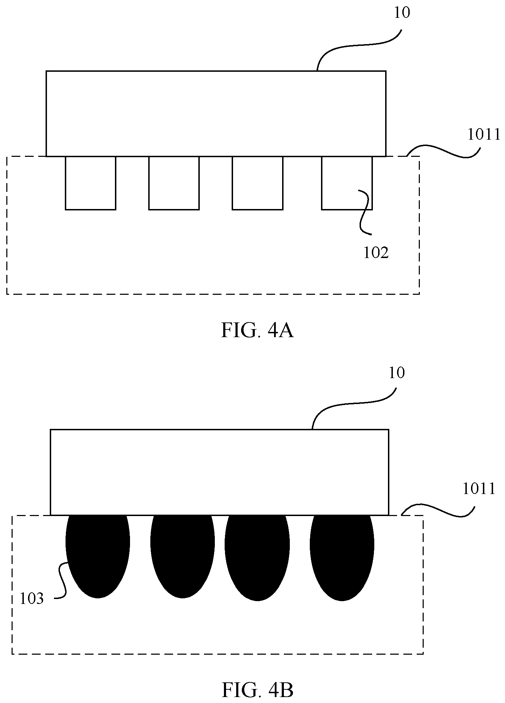

In an implementation of this disclosure, the electrical connector 1011 may be a connection pillar 102 shown in FIG. 4A.

In this case, a material of the connection pillar 102 may be at least one of gold, copper, aluminum, silver, or solder. Considering production costs, copper or solder may be used.

In another implementation of this disclosure, the electrical connector 1011 may alternatively be a micro bump 103 shown in FIG. 4B. A material of the micro bump may be gold.

A side that is of the pad 201 and that is close to the electrical connector 1011 may be covered by using the micro bump 103. The micro bump may be attached to the pad 201, and prevent a metal material of the electrical connector 1011 and an exposed upper-layer metal material of the pad 201 from spreading to each other.

In another implementation of this disclosure, the electrical connector 1011 may include two parts. As shown in FIG. 4C, the electrical connector 1011 includes a first subpart close to the first chip 20 and a second subpart close to a side of the second chip 10. The first subpart of the electrical connector 1011 is connected to the first chip 20, and the second subpart of the electrical connector 1011 is welded to the pad 201. A size of the second subpart of the electrical connector 1011 is, for example, less than the size of the opening on the side that is of the isolation component 202 and that is close to the electrical connector 1011, so that the electrical connector 1011 can enter the isolation component 202.

The first subpart may use the foregoing connection pillar 102, and a material of the first subpart includes at least one of copper, titanium, nickel, tungsten, and silver. A material of the second subpart includes, for example, the solder 1012. In this way, the first subpart may provide a specific hardness for the electrical connector 1011. In addition, the electrical connector 1011 may be connected to the second chip 10 by performing a spot welding process on the second subpart.

A manner of welding the electrical connector 1011 to the pad 201 is not limited in this example of this disclosure. The electrical connector 1011 and the pad 201 may be welded in a mass reflow or thermal compression bonding manner.

In a mass reflow process, air or nitrogen is heated to a sufficiently high temperature and then blown to a substrate on which a chip is attached, so that solder on both sides of the chip is melted and then bonded to the substrate. The temperature is easy to control, oxidation can be avoided in a welding process, and manufacturing costs are also easy to control.

Thermal compression bonding is to add solder such as a metal wire to a head of the electrical connector 1011, and then press-weld the electrical connector 1011 and the pad 201 together through heating and pressure. A principle of thermal compression bonding is that the pad 201 undergoes plastic deformation through heating and pressure, and an oxide layer on a pressure-welding interface is destroyed, so that a gravitational force range of atoms is reached between a contact surface of a pressure-welded metal wire and the pad 201, thereby generating attraction between atoms and achieving bonding.

Then, refer to FIG. 2 and FIG. 3. A gap between the isolation component 202 and the second chip 10 is filled with a filler 40. Therefore, the filler 40 may be used to support the second chip 10, and may further be used to conduct heat, thereby facilitating heat dissipation of a device.

An example of this disclosure further provides a method for manufacturing a stacking structure. FIG. 7 is a flowchart of a method for manufacturing a stacking structure according to an example of this disclosure. The method includes the following steps.

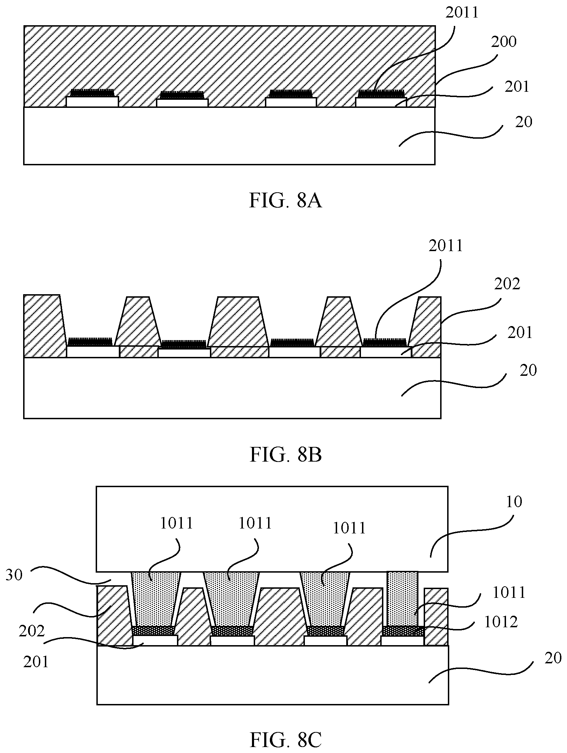

S101: Form a passivation layer 200 on a first surface of a first chip 20 as shown in FIG. 8A.

A plurality of pads 201 are disposed on the first surface of the first chip 20.

The first chip 20 includes a first surface and a second surface that are opposite to each other.

The first chip 20 may be a substrate, a die, or a wafer.

A material of the passivation layer 200 may be an organic material such as polyimide, poly(p-phenylene benzobisoxazole), acrylic acid, or benzocyclobutene, or an inorganic material such as oxide or nitride. For example, the passivation layer 200 may be formed by using a rotary coating process.

A material of the pad 201 is, for example, copper, and there are, for example, a plurality of pads.

S102: As shown in FIG. 8B, etch the passivation layer to form a plurality of isolation components 202, and expose the pads 201.

The etching the passivation layer may include: opening a surface of the passivation layer through photoetching or chemical etching.

A height of the isolation component 202 is, for example, less than or equal to a sum of heights of an electrical connector 1011 and the pad 201.

The isolation component 202 may be an isolation plate disposed between adjacent pads 201, or may be an annular groove disposed around the pad 201. In this example, the isolation component 202 is, for example, the annular groove. A longitudinal section of the isolation component 202 is, for example, a trapezoid, and a size of a section on a side that is of the isolation component 202 and that is close to the pad 201 is less than a size of a section on a side that is of the isolation component 202 and that is close to the electrical connector 1011.

A shape of a cross section of the isolation component 202 is not limited in this example of this disclosure, and may be a circle, a square, a regular polygon, or an irregular shape.

S103: Weld a plurality of electrical connectors 1011 on a second surface of a second chip 10 to the plurality of pads 201 one by one as shown in FIG. 8C, so that melted solder fills a gap between the electrical connector 1011 and the pad 201.

The second chip 10 may be a substrate, a die, or a wafer.

A structure of the electrical connector 1011 is not limited in this example of this disclosure. The electrical connector 1011 may be a micro bump (uBump), a controlled collapse chip connection (C4), a copper pillar (Cu Pillar), or the like. A minimum pitch of the controlled collapse chip connection may be reduced to about 130 um, a minimum pitch of the copper pillar may be reduced to 60 um, and a pitch of the micro bump is reduced to 30 um to 40 um.

The following describes the structure of the electrical connector 1011 in detail.

For example, as shown in FIG. 4A, the electrical connector 1011 may be pillar-shaped, for example, a connection pillar 102. As shown in FIG. 4B, the electrical connector 1011 may alternatively be a micro bump 103. As shown in FIG. 4C, the electrical connector 1011 may alternatively be a combination of the connection pillar 102 and the solder 1012.

A material of the connection pillar 102 may be at least one of copper, aluminum, silver, or solder. Considering production costs, copper or solder may be used. A material of the solder may be tin.

A side that is of the pad 201 and that is close to the electrical connector 1011 may be covered by using the micro bump 103. The micro bump may be attached to the pad 201, and prevent a metal material of the electrical connector 1011 and an exposed upper-layer metal material of the pad 201 from spreading to each other.

The electrical connector 1011 includes a first subpart close to the first chip 20 and a second subpart close to a side of the second chip 10. The first subpart of the electrical connector 1011 is connected to the first chip 20, and the second subpart of the electrical connector 1011 is welded to the pad 201.

The first subpart may use the foregoing connection pillar 102, and a material of the second subpart includes, for example, the solder 1012.

A size of the electrical connector 1011 close to the pad 201 is, for example, less than a size of an opening on the side that is of the isolation component 202 and that is close to the electrical connector 1011, so that the electrical connector 1011 can enter the isolation component 202.

Welding the electrical connectors 1011 to the pads 201 in a one-to-one correspondence may be connecting the electrical connectors 1011 to the pads 201 one by one through mass reflow or thermal compression bonding.

In a mass reflow process, air or nitrogen is heated to a sufficiently high temperature and then blown to the solder between the electrical connector 1011 and the pad 201, so that after the solder between the electrical connector 1011 and the pad 201 is melted, the solder between the electrical connector 1011 and the pad 201 is connected together. The temperature is easy to control, oxidation can be avoided in a welding process, and manufacturing costs are also easier to control.

Thermal compression bonding is to add solder such as a metal wire to a head of the electrical connector 1011, and then press-weld the electrical connector 1011 and the pad 201 together through heating and pressure or by heating and pressurizing a body of the electrical connector 1011. A principle of thermal compression bonding is that the pad 201 undergoes plastic deformation through heating and pressure, and an oxide layer on a pressure-welding interface is destroyed, so that a gravitational force range of atoms is reached between a contact surface of a pressure-welded metal wire and the pad 201, thereby generating attraction between atoms and achieving bonding.

The height of the isolation component 202 is less than or equal to the sum of the heights of the electrical connector 1011 and the pad 201, so that the isolation component 202 can isolate adjacent electrical connectors 1011. More solder may be used when the electrical connector 1011 is connected to the pad 201, and the solder is isolated by the isolation component 202, thereby avoiding a short circuit caused by the solder flowing when the electrical connector 1011 is welded to the pad 201. Larger pressure or a longer welding time may further be used during welding, thereby greatly reducing a risk of the short circuit, improving a welding yield, and improving connection stability.

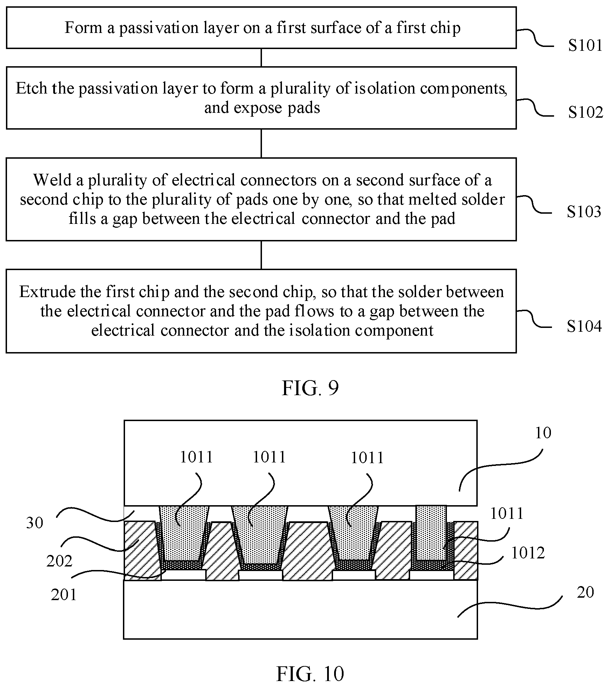

An example of this disclosure further provides a method for manufacturing a chip stacking structure. As shown in FIG. 9, after step S103, the method further includes:
S104: Extrude the first chip 20 and the second chip 10 as shown in FIG. 10, so that the solder between the electrical connector 1011 and the pad 201 flows to a gap between the electrical connector 1011 and the isolation component 202.

The melted solder may further fill the gap between the electrical connector 1011 and the isolation component 202.

Therefore, the solder fills the gap between the electrical connector and the pad and the gap between the electrical connector and the isolation component, thereby improving stability of the electrical connector. Stability of each electrical connector is improved, and a total quantity of electrical connectors can be reduced while connection stability is ensured, thereby reducing sizes of the first chip and the second chip, and facilitating device miniaturization. In this way, a pitch of a device is reduced, a short circuit and the risk of the short circuit are reduced, and a manufacturing yield is improved.

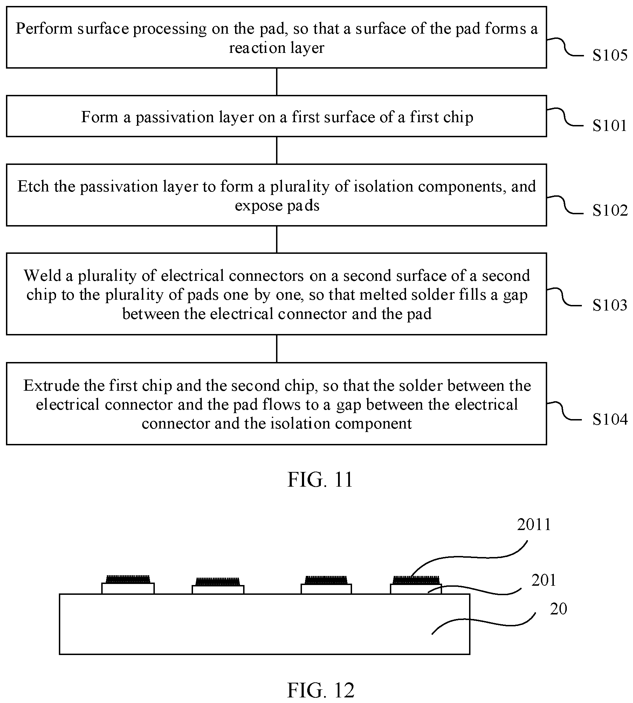

An example of this disclosure further provides a method for manufacturing a chip stacking structure. As shown in FIG. 11, before the forming a passivation layer on a first surface of a first chip 20, the method further includes:
S105: Perform surface processing on the pad 201 as shown in FIG. 12, so that a surface of the pad 201 forms a reaction layer 2011.

A material of the reaction layer 2011 is, for example, NiAu. Au has good solderability. Ni prevents an excessive metallurgical reaction, and may undergo a metallurgical reaction with the electrical connector 1011 during heating. Under effect of heating or another external condition, diffusion of metal atomic bonds can be accelerated, a connection interface can be eliminated, and an intermetallic compound can be formed, to obtain interconnection of to-be-connected objects on both sides. Surface processing is performed on the pad 201, so that reliability of interconnection between the pad 201 and the electrical connector 1011 can be enhanced.

Therefore, the reaction layer 2011 is formed on the surface of the pad by performing surface processing on the pad, so that stability of a connection between the pad and the electrical connector can be improved.

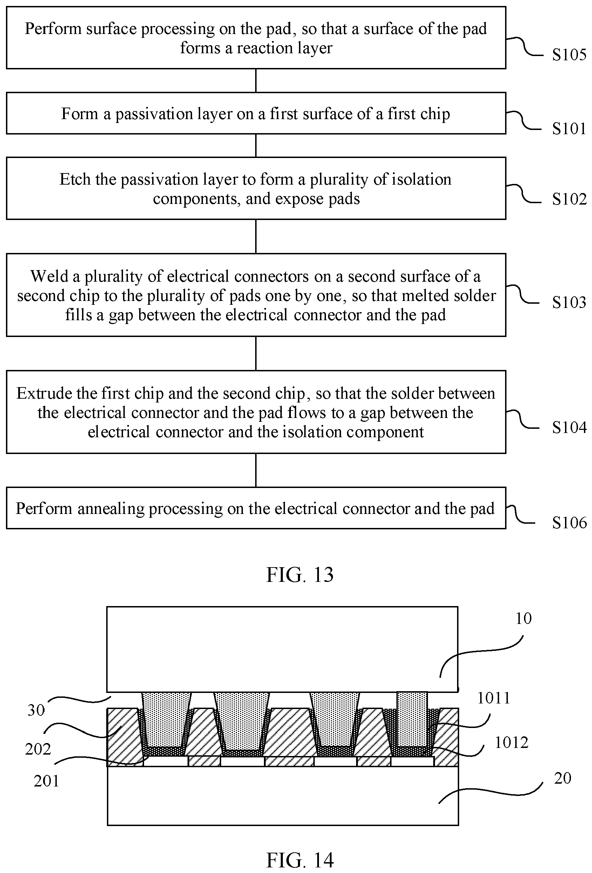

As shown in FIG. 13, after the extruding the first chip 20 and the second chip 10, so that the solder between the electrical connector 1011 and the pad 201 flows to a gap between the electrical connector 1011 and the isolation component 202, the method further includes:
S106: As shown in FIG. 14, perform annealing processing on the electrical connector 1011 and the pad 201.

The annealing processing includes: heating a metal to a specific temperature, keeping the metal for a sufficient time, and then cooling the metal at a suitable speed, to reduce residual stress between the electrical connector 1011 and the pad 201, stabilize a size, and reduce a deformation and crack tendency.

Therefore, stability of the connection between the electrical connector and the pad can be further improved by performing annealing processing on the electrical connector and the pad.

An example of this disclosure further provides a method for manufacturing a chip stacking structure.

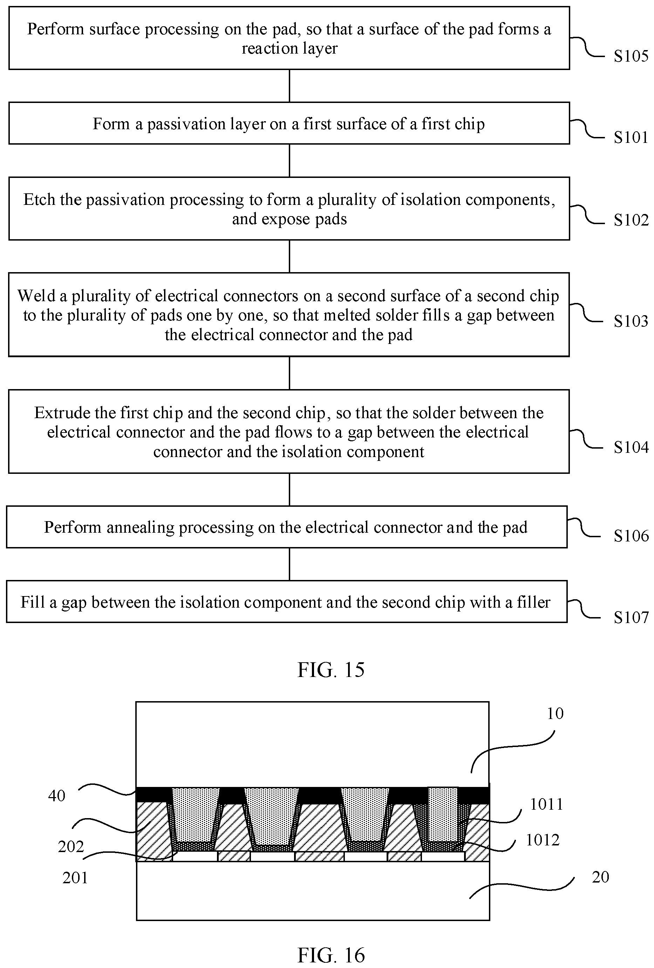

As shown in FIG. 14, if the height of the isolation component 202 is less than the sum of the heights of the electrical connector 1011 and the pad 201, the method for manufacturing a chip stacking structure is shown in FIG. 15. After step S106 of performing annealing processing on the electrical connector 1011 and the pad 201, the method further includes:
S107: As shown in FIG. 16, fill a gap between the isolation component 202 and the second chip 10 with a filler 40.

The filler 40 may be filled in a gap 30 between the isolation component 202 and the second chip 10 by using a capillary action. The filler 40 is made of a thermosetting material. The filler 40 may be configured to carry the second chip 10, and may further conduct heat generated when the first chip 20 works to an external environment in time by using the second chip 10, thereby improving heat dissipation performance of the chip.

Therefore, the gap between the isolation component and the second chip is filled with the filler, so that heat dissipation performance of the chip stacking structure can be improved.

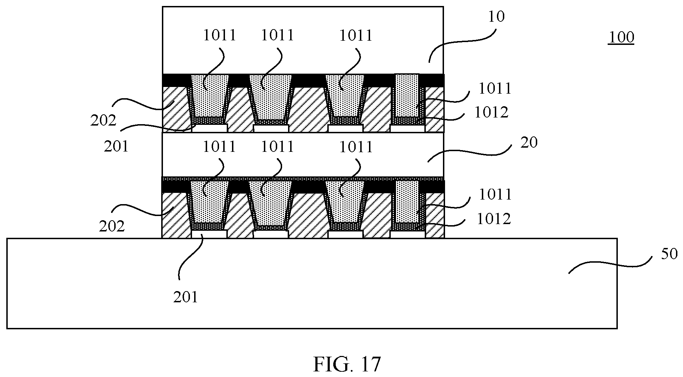

This application further provides an electronic device. FIG. 17 is a schematic diagram of a cross-sectional structure of an electronic device 100 according to this application. The electronic device 100 includes, for example, a printed circuit board 50 and a chip stacking structure disposed on the printed circuit board 50. A structure and a function of the chip stacking package structure are the same as those of the chip stacking structure in the foregoing examples, and details are not described herein again. A first chip 20 of the chip stacking structure is, for example, located between a second chip 10 and the printed circuit board 50.

A connection manner between the chip stacking structure and the printed circuit board is not limited in this example of this disclosure. In an implementation of this disclosure, for example, the second chip 10 may be connected to the printed circuit board by using the foregoing connection structure. As shown in FIG. 17, the printed circuit board 50 and the first chip 20 each include a first surface and a second surface that are opposite to each other. The second surface of the first chip 20 is opposite to the first surface of the printed circuit board 50.

A plurality of electrical connectors 1011 are disposed on the second surface of the first chip 20, and a plurality of pads 201 are disposed on the first surface of the printed circuit board 50. The pads 201 one-to-one correspond to the electrical connectors 1011, and the electrical connectors 1011 are welded to the pads 201.

An isolation component 202 is disposed between adjacent pads 201, and a height of the isolation component 202 is less than or equal to a sum of heights of the electrical connector 1011 and the pad 201. Therefore, the isolation component is disposed between adjacent electrical connectors to isolate the adjacent electrical connectors. More solder may be used when the electrical connector is connected to the pad, and the solder is isolated by the isolation component, thereby avoiding a short circuit caused by the melted solder flowing when the electrical connector is welded to the pad. More solder, larger pressure, or a longer welding time may further be used during welding, greatly reducing a risk of an open circuit.

A gap between the electrical connector 1011 and the pad 201 and a gap between the electrical connector 1011 and the isolation component 202 are filled with solder 1012. Therefore, the solder 1012 fills the gap between the electrical connector 1011 and the pad 201 and the gap between the electrical connector 1011 and the isolation component 202, so that electrical connection stability of the electrical connector can be improved. Stability of each electrical connector is improved, and a total quantity of electrical connectors can be reduced while connection stability is ensured, thereby reducing sizes of the printed circuit board 50 and the chip stacking structure, and facilitating device miniaturization.

Therefore, the electronic device is connected to the foregoing chip stacking structure by using the foregoing connection structure, so that connection stability is higher, a pitch between electrical connectors can be reduced, and the size is smaller, thereby facilitating device miniaturization.

## Claims

1. A chip stacking structure, comprising: a first chip (20) and a second chip (10) that are disposed in a stacked manner, wherein
a first surface of the first chip (20) is opposite to a second surface of the second chip (10), a plurality of pads (201) are disposed on the first surface of the first chip (20), a plurality of electrical connectors (1011) are disposed on the second surface of the second chip (10), and the plurality of pads (201) are connected to the plurality of electrical connectors (1011) in a one-to-one correspondence;
a plurality of isolation components (202) made of insulation materials are further disposed on the first surface of the first chip (20), the isolation component (202) is located between adjacent pads (201), and a height of the isolation component (202) is less than or equal to a sum of heights of the electrical connector (1011) and the pad (201);
the isolation component (202) comprises an annular groove disposed around the pad (201);
a gap (30) between the electrical connector (1011) and the pad (201) as well as a gap between an outer sidewall of the electrical connector (1011) and an inner sidewall of the annular groove are filled with solder (1012); and
a gap between the isolation component (202) and the second chip (10) is filled with a filler (40) made of a thermosetting material.

2. The stacking structure according to claim 1, wherein a longitudinal section of the annular groove is a trapezoid, and a size of an opening on a side that is of the annular groove and that is close to the pad (201) is less than a size of an opening on a side that is of the annular groove and that is close to the electrical connector (1011).

3. The stacking structure according to any one of claims 1 to 2, wherein the electrical connector (1011) comprises a first subpart close to the second chip (10) and a second subpart close to the pad (201);
a material of the first subpart comprises at least one of copper or gold; and
a material of the second subpart comprises the solder (1012).

4. A method for manufacturing a chip stacking structure, comprising:
forming a passivation layer on a first surface of a first chip (20), wherein a plurality of pads (201) are disposed on the first surface of the first chip (20);
etching the passivation layer to form a plurality of isolation components (202), so that the pads (201) are exposed;
welding a plurality of electrical connectors (1011) on a second surface of a second chip (10) to the plurality of pads (201) one by one, so that melted solder (1012) fills a gap (30) between the electrical connector (1011) and the pad (201), wherein a height of the isolation component (202) is less than or equal to a sum of heights of the electrical connector (1011) and the pad (201), wherein the isolation component (202) comprises an annular groove disposed around the pad (201), and when the electrical connector (1011) is welded to the pad (201), the melted solder (1012) fills the annular groove, so that not only the gap (30) between the electrical connector (1011) and the pad (201) but also a gap between an outer sidewall of the electrical connector (1011) and an inner sidewall of the annular groove structure are filled with the melted solder (1012); and
after the welding the plurality of electrical connectors (1011) on the second surface of the second chip (10) to the plurality of pads (201) one by one, filling a gap between the isolation component (202) and the second chip (10) with a filler (40) made of a thermosetting material.

5. The method for manufacturing a chip stacking structure according to claim 4, wherein the method further comprises: pressing the first chip (20) and the second chip (10), so that the solder (1012) between the electrical connector (1011) and the pad (201) flows to the gap (30) between the electrical connector (1011) and the isolation component (202).

6. The method for manufacturing a chip stacking structure according to claim 4 or 5 wherein before the forming a passivation layer on a first surface of a first chip (20), the method further comprises:
performing surface processing on the pad (201), so that a surface of the pad (201) forms a reaction layer (2011), wherein a metallurgical reaction occurs when the reaction layer (2011) is welded to the electrical connector (1011).

7. The method for manufacturing a chip stacking structure according to any one of claims 4 to 6,
the filler (40) is filled in the gap between the isolation component (202) and the second chip (10) by using a capillary action.

8. The method for manufacturing a chip stacking structure according to claim 4, wherein a longitudinal section of the annular groove is a trapezoid, and a size of an opening on a side that is of the isolation component (202) and that is close to the pad (201) is less than a size of an opening on a side that is of the isolation component (202) and that is close to the electrical connector (1011).

9. The method for manufacturing a chip stacking structure according to any one of claims 4 to 8 wherein the electrical connectors (1011) are of different heights, and solder is added to only heads of the electrical connectors (1011), so that shapes of the finally formed electrical connectors (1011) match a shape of the annular groove.

10. The method for manufacturing a chip stacking structure according to any one of claims 4 to 9, wherein the inner sidewall of the annular groove is configured to block the electrical connector (1011) from tilting in a pressing process of the electrical connector (1011).

11. The method for manufacturing a chip stacking structure according to any one of claims 4 to 10 wherein a cross section of the annular groove is a circle, a square or a regular polygon.

12. The method for manufacturing a chip stacking structure according to any one of claims 4 to 11, wherein the electrical connector (1011) comprises a first subpart close to the second chip (10) and a second subpart close to the pad (201);
a material of the first subpart comprises at least one of copper or gold; and
a material of the second subpart comprises the solder (1012).

13. An electronic device (100), comprising a printed circuit board (50) and the chip stacking structure according to any one of claims 1 to 4, wherein the chip stacking structure is electrically connected to the printed circuit board (50).

## Patentansprüche

1. Chipstapelstruktur, die umfasst: einen ersten Chip (20) und einen zweiten Chip (10), die in einer gestapelten Weise angeordnet sind, wobei
eine erste Oberfläche des ersten Chips (20) einer zweiten Oberfläche des zweiten Chips (10) gegenüberliegt, eine Vielzahl von Kontaktstellen (201) auf der ersten Oberfläche des ersten Chips (20) angeordnet ist, eine Vielzahl von elektrischen Verbindern (1011) auf der zweiten Oberfläche des zweiten Chips (10) angeordnet ist und die Vielzahl von Kontaktstellen (201) mit der Vielzahl von elektrischen Verbindern (1011) in einer Eins-zu-Eins-Entsprechung verbunden ist;
eine Vielzahl von Isolationskomponenten (202), gefertigt aus Isolationsmaterialien, ferner auf der ersten Oberfläche des ersten Chips (20) angeordnet ist, sich die Isolationskomponente (202) zwischen angrenzenden Kontaktstellen (201) befindet und eine Höhe der Isolationskomponente (202) geringer als oder gleich einer Summe der Höhen des elektrischen Verbinders (1011) und der Kontaktstelle (201) ist;
die Isolationskomponente (202) eine Ringnut, die um die Kontaktstelle (201) herum angeordnet ist, umfasst;
ein Spalt (30) zwischen dem elektrischen Verbinder (1011) und der Kontaktstelle (201) sowie ein Spalt zwischen einer äußeren Seitenwand des elektrischen Verbinders (1011) und einer inneren Seitenwand der Ringnut mit Lötzinn (1012) gefüllt sind; und ein Spalt zwischen der Isolationskomponente (202) und dem zweiten Chip (10) mit einem Füllstoff (40), gefertigt aus einem wärmehärtenden Material, gefüllt ist.

2. Stapelstruktur nach Anspruch 1, wobei ein Längsabschnitt der Ringnut ein Trapez ist und eine Größe einer Öffnung auf einer Seite, die zu der Ringnut gehört und die nahe der Kontaktstelle (201) liegt, geringer als eine Größe einer Öffnung auf einer Seite, die zu der Ringnut gehört und die nahe dem elektrischen Verbinder (1011) liegt, ist.

3. Stapelstruktur nach einem der Ansprüche 1 bis 2, wobei der elektrische Verbinder (1011) einen ersten Teilbereich nahe dem zweiten Chip (10) und einen zweiten Teilbereich nahe der Kontaktstelle (201) umfasst;
ein Material des ersten Teilbereichs mindestens eines von Kupfer oder Gold umfasst; und ein Material des zweiten Teilbereichs das Lötzinn (1012) umfasst.

4. Verfahren zum Herstellen einer Chipstapelstruktur, das umfasst:
Ausbilden einer Passivierungsschicht auf einer ersten Oberfläche eines ersten Chips (20), wobei eine Vielzahl von Kontaktstellen (201) auf der ersten Oberfläche des ersten Chips (20) angeordnet ist;
Ätzen der Passivierungsschicht, um eine Vielzahl von Isolationskomponenten (202) auszubilden, sodass die Kontaktstellen (201) freigelegt werden;
Schweißen einer Vielzahl von elektrischen Verbindern (1011) auf einer zweiten Oberfläche eines zweiten Chips (10) an die Vielzahl von Kontaktstellen (201) nacheinander, sodass geschmolzenes Lötzinn (1012) einen Spalt (30) zwischen dem elektrischen Verbinder (1011) und der Kontaktstelle (201) füllt, wobei eine Höhe der Isolationskomponente (202) geringer als oder gleich einer Summe von Höhen des elektrischen Verbinders (1011) und der Kontaktstelle (201) ist, wobei die Isolationskomponente (202) eine Ringnut, die um die Kontaktstelle (201) herum angeordnet ist, umfasst und wenn der elektrische Verbinder (1011) an die Kontaktstelle (201) geschweißt wird, das geschmolzene Lötzinn (1012) die Ringnut füllt, sodass nicht nur der Spalt (30) zwischen dem elektrischen Verbinder (1011) und der Kontaktstelle (201), sondern auch ein Spalt zwischen einer äußeren Seitenwand des elektrischen Verbinders (1011) und einer inneren Seitenwand der Ringnutstruktur mit dem geschmolzenen Lötzinn (1012) gefüllt sind; und
nach dem Schweißen der Vielzahl von elektrischen Verbindern (1011) auf der zweiten Oberfläche des zweiten Chips (10) an die Vielzahl von Kontaktstellen (201) nacheinander, Füllen eines Spalts zwischen der Isolationskomponente (202) und dem zweiten Chip (10) mit einem Füllstoff (40), gefertigt aus einem wärmehärtenden Material.

5. Verfahren zum Herstellen einer Chipstapelstruktur nach Anspruch 4, wobei das Verfahren ferner umfasst:
Pressen des ersten Chips (20) und des zweiten Chips (10), sodass das Lötzinn (1012) zwischen dem elektrischen Verbinder (1011) und der Kontaktstelle (201) zu dem Spalt (30) zwischen dem elektrischen Verbinder (1011) und der Isolationskomponente (202) fließt.

6. Verfahren zum Herstellen einer Chipstapelstruktur nach Anspruch 4 oder 5, wobei vor dem Ausbilden einer Passivierungsschicht auf einer ersten Oberfläche eines ersten Chips (20) das Verfahren ferner umfasst:
Durchführen einer Oberflächenbehandlung an der Kontaktstelle (201), sodass eine Oberfläche der Kontaktstelle (201) eine Reaktionsschicht (2011) ausbildet, wobei eine metallurgische Reaktion stattfindet, wenn die Reaktionsschicht (2011) an den elektrischen Verbinder (1011) geschweißt wird.

7. Verfahren zum Herstellen einer Chipstapelstruktur nach einem der Ansprüche 4 bis 6, wobei der Füllstoff (40) durch Verwenden einer Kapillarwirkung in den Spalt zwischen der Isolationskomponente (202) und dem zweiten Chip (10) gefüllt wird.

8. Verfahren zum Herstellen einer Chipstapelstruktur nach Anspruch 4, wobei ein Längsabschnitt der Ringnut ein Trapez ist und eine Größe einer Öffnung auf einer Seite, die zu der Isolationskomponente (202) gehört und die nahe der Kontaktstelle (201) liegt, geringer als eine Größe einer Öffnung auf einer Seite, die zu der Isolationskomponente (202) gehört und die nahe dem elektrischen Verbinder (1011) liegt, ist.

9. Verfahren zum Herstellen einer Chipstapelstruktur nach einem der Ansprüche 4 bis 8, wobei die elektrischen Verbinder (1011) unterschiedliche Höhen vorweisen und Lötzinn nur an Köpfen der elektrischen Verbinder (1011) hinzugefügt wird, sodass Formen der endgültig ausgebildeten elektrischen Verbinder (1011) einer Form der Ringnut entsprechen.

10. Verfahren zum Herstellen einer Chipstapelstruktur nach einem der Ansprüche 4 bis 9, wobei die innere Seitenwand der Ringnut konfiguriert ist, um den elektrischen Verbinder (1011) daran zu hindern, in einem Pressprozess des elektrischen Verbinders (1011) zu kippen.

11. Verfahren zum Herstellen einer Chipstapelstruktur nach einem der Ansprüche 4 bis 10, wobei ein Querschnitt der Ringnut ein Kreis, ein Quadrat oder ein regelmäßiges Polygon ist.

12. Verfahren zum Herstellen einer Chipstapelstruktur nach einem der Ansprüche 4 bis 11, wobei der elektrische Verbinder (1011) einen ersten Teilbereich nahe dem zweiten Chip (10) und einen zweiten Teilbereich nahe der Kontaktstelle (201) umfasst;
ein Material des ersten Teilbereichs mindestens eines von Kupfer oder Gold umfasst; und ein Material des zweiten Teilbereichs das Lötzinn (1012) umfasst.

13. Elektronische Vorrichtung (100), die eine Leiterplatte (50) und die Chipstapelstruktur nach einem der Ansprüche 1 bis 4 umfasst, wobei die Chipstapelstruktur mit der Leiterplatte (50) elektrisch verbunden ist.

## Revendications

1. Structure d'empilement de puces, comprenant : une première puce (20) et une seconde puce (10) qui sont disposées de manière empilée, dans laquelle
une première surface de la première puce (20) est opposée à une seconde surface de la seconde puce (10), une pluralité de plots (201) sont disposés sur la première surface de la première puce (20), une pluralité de connecteurs électriques (1011) sont disposés sur la seconde surface de la seconde puce (10), et la pluralité de plots (201) sont connectés à la pluralité de connecteurs électriques (1011) dans une correspondance biunivoque ;
une pluralité de composants d'isolation (202) constitués de matériaux d'isolation sont en outre disposés sur la première surface de la première puce (20), le composant d'isolation (202) est situé entre des plots (201) adjacents, et une hauteur du composant d'isolation (202) est inférieure ou égale à une somme de hauteurs du connecteur électrique (1011) et du plot (201) ;
le composant d'isolation (202) comprend une rainure annulaire disposée autour du plot (201) ;
un espace (30) entre le connecteur électrique (1011) et le plot (201) ainsi qu'un espace entre une paroi latérale externe du connecteur électrique (1011) et une paroi latérale interne de la rainure annulaire sont remplis de soudure (1012) ; et
un espace entre le composant d'isolation (202) et la seconde puce (10) est rempli d'une charge (40) constituée d'un matériau thermodurcissable.

2. Structure d'empilement selon la revendication 1, dans laquelle une section longitudinale de la rainure annulaire est un trapèze, et une taille d'une ouverture sur un côté qui appartient à la rainure annulaire et qui est proche du plot (201) est inférieure à une taille d'une ouverture sur un côté qui appartient à la rainure annulaire et qui est proche du connecteur électrique (1011).

3. Structure d'empilement selon l'une quelconque des revendications 1 à 2, dans laquelle le connecteur électrique (1011) comprend une première sous-partie proche de la seconde puce (10) et une seconde sous-partie proche du plot (201) ;
un matériau de la première sous-partie comprend au moins l'un parmi cuivre ou or ; et un matériau de la seconde sous-partie comprend la soudure (1012).

4. Procédé pour la fabrication d'une structure d'empilement de puces, comprenant :
la formation d'une couche de passivation sur une première surface d'une première puce (20), dans lequel une pluralité de plots (201) sont disposés sur la première surface de la première puce (20) ;
la gravure de la couche de passivation pour former une pluralité de composants d'isolation (202), de sorte que les plots (201) sont exposés ;
le soudage d'une pluralité de connecteurs électriques (1011) sur une seconde surface d'une seconde puce (10) à la pluralité de plots (201) un par un, de sorte que de la soudure fondue (1012) remplit un espace (30) entre le connecteur électrique (1011) et le plot (201), dans lequel une hauteur du composant d'isolation (202) est inférieure ou égale à une somme de hauteurs du connecteur électrique (1011) et du plot (201), dans lequel le composant d'isolation (202) comprend une rainure annulaire disposée autour du plot (201), et lorsque le connecteur électrique (1011) est soudé au plot (201), la soudure fondue (1012) remplit la rainure annulaire, de sorte que non seulement l'espace (30) entre le connecteur électrique (1011) et le plot (201), mais également un espace entre une paroi latérale externe du connecteur électrique (1011) et une paroi latérale interne de la structure de rainure annulaire, sont remplis de la soudure fondue (1012) ; et
après le soudage de la pluralité de connecteurs électriques (1011) sur la seconde surface de la seconde puce (10) à la pluralité de plots (201) un par un, le remplissage d'un espace entre le composant d'isolation (202) et la seconde puce (10) d'une charge (40) constituée d'un matériau thermodurcissable.

5. Procédé pour la fabrication d'une structure d'empilement de puces selon la revendication 4, dans lequel le procédé comprend en outre :
la pression de la première puce (20) et de la seconde puce (10), de sorte que la soudure (1012) entre le connecteur électrique (1011) et le plot (201) s'écoule dans l'espace (30) entre le connecteur électrique (1011) et le composant d'isolation (202).

6. Procédé pour la fabrication d'une structure d'empilement de puces selon la revendication 4 ou 5, dans lequel, avant la formation d'une couche de passivation sur une première surface d'une première puce (20), le procédé comprend en outre :
la réalisation d'un traitement de surface sur le plot (201), de sorte qu'une surface du plot (201) forme une couche de réaction (2011), dans lequel une réaction métallurgique se produit lorsque la couche de réaction (2011) est soudée au connecteur électrique (1011).

7. Procédé pour la fabrication d'une structure d'empilement de puces selon l'une quelconque des revendications 4 à 6, la charge (40) est introduite dans l'espace entre le composant d'isolation (202) et la seconde puce (10) pour le remplir en utilisant une action capillaire.

8. Procédé pour la fabrication d'une structure d'empilement de puces selon la revendication 4, dans lequel une section longitudinale de la rainure annulaire est un trapèze, et une taille d'une ouverture sur un côté qui appartient au composant d'isolation (202) et qui est proche du plot (201) est inférieure à une taille d'une ouverture sur un côté qui appartient au composant d'isolation (202) et qui est proche du connecteur électrique (1011).

9. Procédé pour la fabrication d'une structure d'empilement de puces selon l'une quelconque des revendications 4 à 8, dans lequel les connecteurs électriques (1011) sont de hauteurs différentes, et de la soudure est ajoutée uniquement à des têtes des connecteurs électriques (1011), de sorte que des formes des connecteurs électriques (1011) définitivement formés correspondent à une forme de la rainure annulaire.

10. Procédé pour la fabrication d'une structure d'empilement de puces selon l'une quelconque des revendications 4 à 9, dans lequel la paroi latérale interne de la rainure annulaire est conçue pour bloquer l'inclinaison du connecteur électrique (1011) lors d'un processus de pressage du connecteur électrique (1011).

11. Procédé pour la fabrication d'une structure d'empilement de puces selon l'une quelconque des revendications 4 à 10, dans lequel une section transversale de la rainure annulaire est un cercle, un carré ou un polygone régulier.

12. Procédé pour la fabrication d'une structure d'empilement de puces selon l'une quelconque des revendications 4 à 11, dans lequel le connecteur électrique (1011) comprend une première sous-partie proche de la seconde puce (10) et une seconde sous-partie proche du plot (201) ;
un matériau de la première sous-partie comprend au moins l'un parmi cuivre ou or ; et un matériau de la seconde sous-partie comprend la soudure (1012).

13. Dispositif électronique (100), comprenant une carte de circuit imprimé (50) et la structure d'empilement de puces selon l'une quelconque des revendications 1 à 4, dans lequel la structure d'empilement de puces est connectée électriquement à la carte de circuit imprimé (50).
